# EUROPEAN PATENT APPLICATION

(11) **EP 4 294 144 A1**
(43) Date of publication of application: **20.12.2023**
(21) Application number: 22187031.4
(22) Date of filing: 26.07.2022
(51) Int. Cl.: H10B 10/00, H01L 27/02, G06F 30/392

(54) **STATIC RANDOM ACCESS MEMORY ARRAY PATTERN**

(30) Priority: 13.06.2022 TW 111121845
(71) Applicant: United Microelectronics Corp., Hsin-Chu City 300 (TW)
(72) Inventor: HUANG, Chun-Hsien, 722 Tainan City (TW); KUO, Yu-Tse, 721 Tainan City (TW); WANG, Shu-Ru, 435 Taichung City (TW); HUANG, Li-Ping, 351 Miaoli County (TW); TSENG, Chun-Yen, 701 Tainan City (TW)
(74) Representative: Isarpatent

(57) **Abstract**

The invention provides a static random access memory (SRAM) array pattern, which comprises a substrate, a first region, a second region, a third region and a fourth region are defined on the substrate and arranged in an array, each region partially overlaps with the other three regions, and each region contains a SRAM cell, the layout of the SRAM cell in the first region is the same as that in the third region, the layout of the SRAM cell in the second region is the same as that in the fourth region, and the layout of the SRAM cell in the first region and the layout of the SRAM cell in the fourth region are mirror patterns along a horizontal axis.

## Description

### Background of the Invention

The present invention relates to a static random access memory (SRAM), in particular to a repeatable array pattern of SRAM.

An embedded static random access memory (SRAM) comprises a logic circuit and a static random access memory connected to the logic circuit. SRAM is a kind of volatile memory cell, which means it preserves data only while power is continuously applied. SRAM is built of cross-coupled inverters that store data during the time that power remains applied, unlike dynamic random access memory (DRAM) that needs to be periodically refreshed. Because of its high access speed, SRAM is also used in computer systems as a cache memory.

However, as gap of the exposure process decreases, it has been difficult for the current SRAM architecture to produce desirable patterns. Hence, how to enhance the current SRAM architecture for improving exposure quality has become an important task in this field.

### Summary of the Invention

The invention provides a static random access memory (SRAM) array pattern, which comprises a substrate, a first region, a second region, a third region and a fourth region are defined on the substrate and arranged in an array, each region partially overlaps with the other three regions, and each region contains a SRAM cell, the layout of the SRAM cell in the first region is the same as that in the third region, the layout of the SRAM cell in the second region is the same as that in the fourth region, and the layout of the SRAM cell in the first region and the layout of the SRAM cell in the fourth region are mirror patterns along a horizontal axis.

The invention is characterized in that a layout pattern of SRAM cell is designed and arranged into an array to form an SRAM array pattern. Parts of SRAM cell can share elements, such as contact plugs. Therefore, the effects of simplifying the manufacturing process and reducing the cell area can be achieved.

These and other objectives of the present invention will no doubt become obvious to those of ordinary skill in the art after reading the following detailed description of the preferred embodiment that is illustrated in the various figures and drawings.

### Brief Description of the Drawings

Fig. 1 is a circuit diagram of an SRAM cell of the present invention.
Fig. 2, Fig. 3 and Fig. 4 are layout diagrams of static random access memory (SRAM) cells in a preferred embodiment of the present invention.
Fig. 5 is a schematic diagram of arranging four SRAM cells in an SRAM array pattern according to an embodiment of the present invention.
Fig. 6 shows the layout pattern of a SRAM cell in another embodiment of the present invention.

### Detailed Description

To provide a better understanding of the present invention to users skilled in the technology of the present invention, preferred embodiments are detailed as follows. The preferred embodiments of the present invention are illustrated in the accompanying drawings with numbered elements to clarify the contents and the effects to be achieved.

Please note that the figures are only for illustration and the figures may not be to scale. The scale may be further modified according to different design considerations. When referring to the words "up" or "down" that describe the relationship between components in the text, it is well known in the art and should be clearly understood that these words refer to relative positions that can be inverted to obtain a similar structure, and these structures should therefore not be precluded from the scope of the claims in the present invention.

The invention provides an array pattern of an embedded static random access memory (embedded SRAM). More specifically, the smallest SRAM array pattern of the present invention will be composed of four SRAM cell arranged in a 2X2 array. For the convenience of explanation, the circuit of a single SRAM cell and its layout pattern are introduced below, as shown in the following paragraphs.

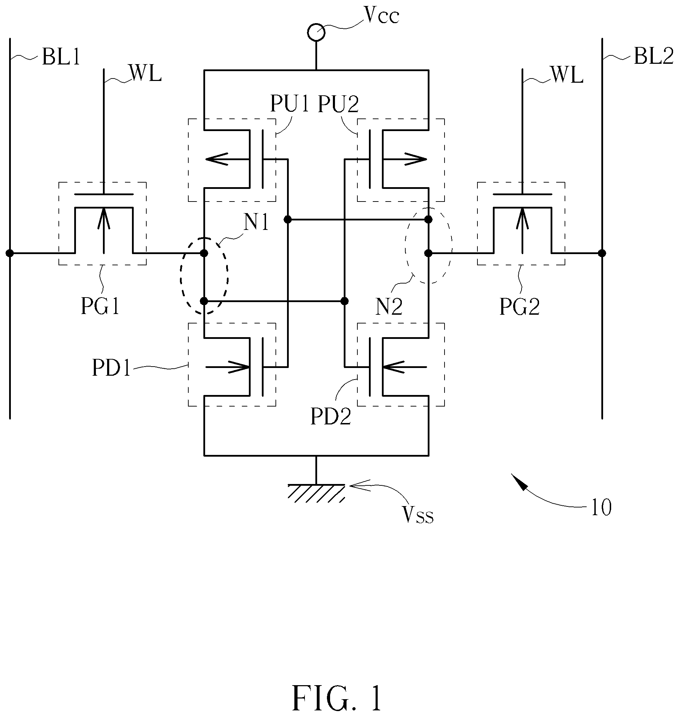

Please refer to Fig. 1, which shows a circuit diagram of an SRAM cell of the present invention. In this embodiment, a 6T-SRAM cell 10 is composed of a first pull-up device PU1, a second pull-up device PU2, and a first pull-down device PD1, a second pull-down device PD2, a first access transistor PG1 and a second access transistor PG2. These six devices (transistors) constitute a set of flip-flops. The first and the second pull-up devices PU1 and PU2, and the first and the second pull-down devices PD1 and PD2 constitute a latch circuit that stores data in the storage nodes N1 and N2. Since the first and the second pull-up devices PU1 and PU2 act as power load devices, they can be replaced by resistors. Under this circumstance, the static random access memory becomes a four-transistor SRAM (4T-SRAM). In this embodiment, the first and the second pull-up devices PU1 and PU2 preferably share a source/drain region and electrically connect to a voltage source (voltage node) Vcc, and the first and the second pull-down devices PD1 and PD2 share a source/drain region and electrically connect to a voltage source (voltage node) Vss.

Preferably, the first and the second pull-up devices PU1 and PU2 of the 6T-SRAM cell 10 are composed of p-type metal oxide semiconductor (PMOS) transistors; the first and the second pull-down devices PD1 and PD2, the first access transistor PG1 and the second access transistor PG2 composed of n-type metal oxide semiconductor (NMOS) transistors, but not limited thereto. The first pull-up device PU1 and the first pull-down device PD1 constitute an inverter, which further form a series circuit. One end of the series circuit is connected to a voltage source Vcc and the other end of the series circuit is connected to a voltage source Vss. Similarly, the second pull-up device PU2 and the second pull-down device PD2 constitute another inverter and a series circuit. One end of the series circuit is connected to the voltage source Vcc and the other end of the series circuit is connected to the voltage source Vss. The two inverters are cross-coupled to each other to storage data.

The storage node N1 is connected to the respective gates of the second pull-down device PD2 and the second pull-up device PU2. The storage node N1 is also connected to the drains of the first pull-down device PD1, the first pull-up device PU1 and the first access transistor PG1. Similarly, the storage node N2 is connected to the respective gates of the first pull-down device PD1 and first the pull-up device PU1. The storage node N2 is also connected to the drains of the second pull-down device PD2, the second pull-up device PU2 and the second access transistor PG2. The gates of the first access transistor PG1 and the second access transistor PG2 are respectively coupled to a word line (WL); the source of the first access transistor PG1 and the second access transistor PG2 are respectively coupled to a first bit line (BL1) and a second bit line (BL2).

The SRAM cell 10 includes six transistors, so it can be called a six-transistors static random access memory (6T-SRAM). However, the SRAM cell of the present invention is not limited to 6T-SRAM, and other SRAM patterns with more transistors, such as 8T-SRAM and 10T-SRAM, can also be used as the SRAM cell of the present invention. In addition, each of the above transistors can also include other combinations of P-type transistors and N-type transistors, and the SRAM cell of the present invention can be applied to planar transistors or three-dimensional field effect transistors (i.e., fin-FET). The following layout pattern takes three-dimensional field effect transistors as an example.

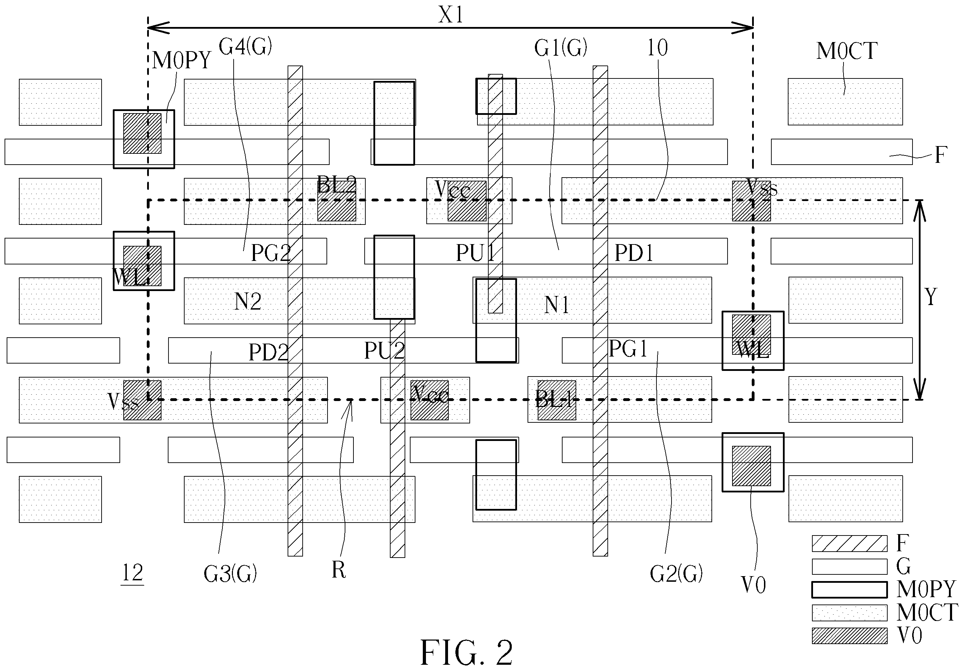

Figs. 2-4 are layout diagrams of static random access memory (SRAM) cells in a preferred embodiment of the present invention. In this embodiment, the SRAM cell 10 is located in a region R and is disposed on a substrate 12, such as a silicon substrate or an SOI substrate. The substrate 12 is provided with a plurality of fin structures F arranged in parallel with each other, and shallow trench isolation (not shown) is arranged around each fin structure F.

In addition, the substrate 12 includes a plurality of gate structures G, and each of the above-mentioned transistors (including the first pull-up transistor PU1, the second pull-up transistor PU2, the first pull-down transistor PD1, the second pull-down transistor PD2, the first access transistor PG1, and the second access transistor PG2) includes a gate structure G across at least one fin structure F, and constitutes each transistor.

As shown in Fig. 2, in order to clearly define the position of each gate structure G, a first gate structure G1, a second gate structure G2, a third gate structure G3, and a fourth gate structure G4 are further defined. The first gate structure G1 crosses the fin structure F to form a first pull-up transistor PU1 and a first pull-down transistor PD1; the second gate structure G2 crosses the fin structure F to form the first access transistor PG1; the third gate structure G3 crosses the fin structure F to form a second pull-up transistor PU2 and a second pull-down transistor PD2; the fourth gate structure G4 crosses the fin structure F to form the second access transistor PG2. It can be understood that the first to fourth gate structures G1, G2, G3 and G4 all belong to the gate structure G.

In the present invention, the gate structures G1, G2, G3, G4 are strip-shaped structures, all of which are arranged along a first direction (e.g., X axis), and each fin structure F is arranged along a second direction (e.g., Y axis). Preferably, the first direction and the second direction are perpendicular to each other.

The region R also contains a plurality of metal layers, where the metal layer partially connecting the gates of each transistor is defined as MOPY, and the metal layer connecting the source/drain of each transistor is defined as MOCT. In Fig. 2, the metal layer MOPY and the metal layer MOCT are represented by different shading. However, the difference between the metal layer MOPY and the metal layer MOCT is that the connected components are different. Both of them actually belong to metal layers and can contain the same material, but they are not limited to this. In addition, in Fig. 2, the transistors, storage nodes, word lines, bit lines, voltage sources, etc. to which each element is connected are marked on the metal layers MOPY, MOCT or the gate structures G to clearly show the connection relationship of each element.

In addition, Fig. 2 also includes a plurality of contact plugs (via)V0, wherein the contact plugs V0 are used to connect the metal layers MOPY and MOCT to other conductive layers (such as M1, V1, M2, etc., which are common in semiconductor manufacturing processes) formed subsequently. Similarly, for clearer explanation, each contact plug V0 in Fig. 2 indicates the connected voltage source, word line, bit line, etc.

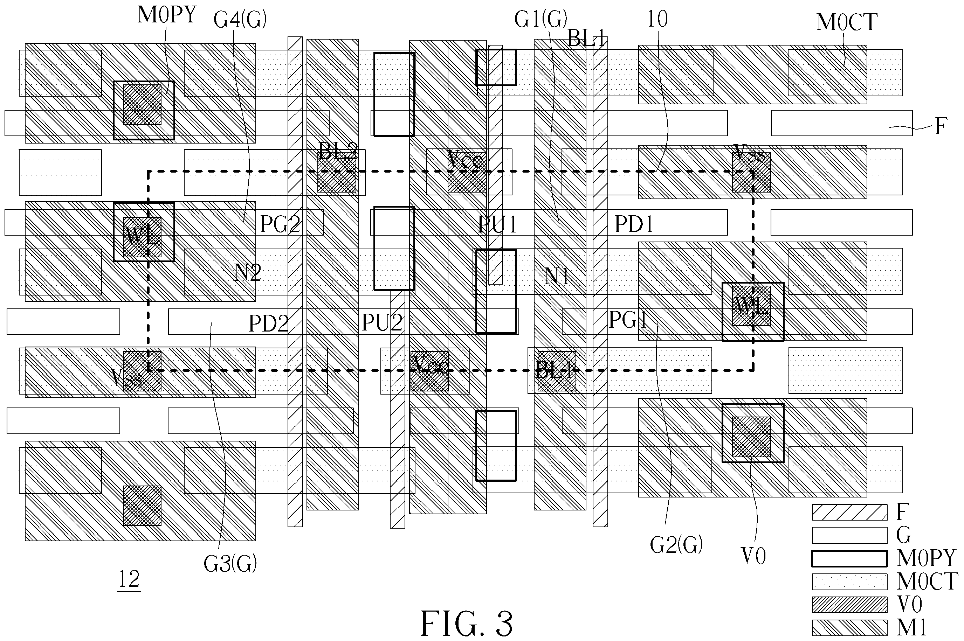

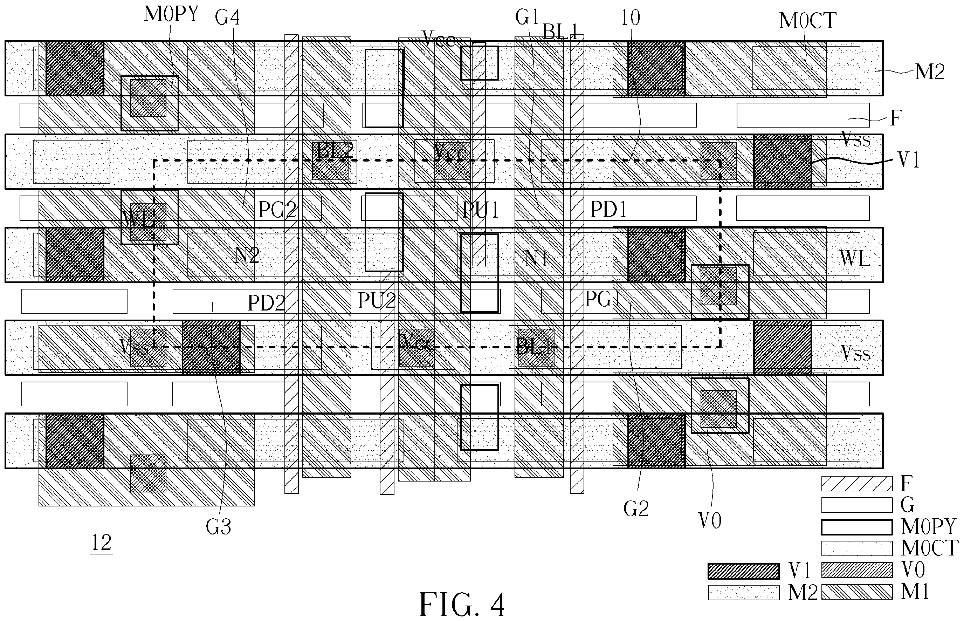

As shown in the subsequent Figs. 3 and 4, a plurality of metal trace and other contact plugs (via) are continuously formed on the metal layers MOPY and MOCT, the contact plugs V0 and the gate structure G to connect each transistor to the corresponding device, voltage source, word line, bit line, etc. As shown in Fig. 3, a plurality of metal traces M1 are formed, and then as shown in Fig. 4, a plurality of contact plugs V1 and a plurality of metal traces M2 are continuously formed. It is worth noting that the contact plug V1 is arranged in the peripheral region of the transistors (such as PG1, PD1, etc.), so it is beneficial for the adjacent SRAM cell to share the contact plug V1 in the subsequent SRAM array pattern. In addition, in order to simplify the drawings, in Figs. 3 and 4, some elements belonging to the layout pattern of the previous layer are not labeled, but only different shades are used to indicate the elements. For those elements that are not labeled, please refer to Fig. 2 to clarify their positions.

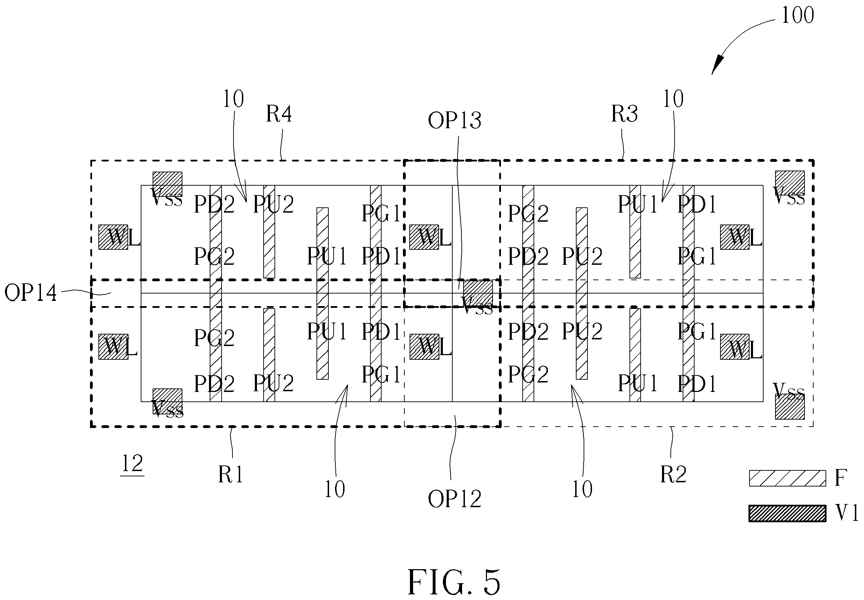

The layout pattern of a single SRAM cell 10 has been shown in the above Figs. 2 to 4, while the SRAM array pattern with the smallest unit provided by the present invention is arranged by four SRAM cells 10. Fig. 5 is a schematic diagram of arranging four SRAM cells in an SRAM array pattern according to an embodiment of the present invention.

As shown in Fig. 5, the SRAM array pattern 100 is arranged by four SRAM cells 10. It is worth noting that the SRAM array pattern 100 of the present invention is characterized in that the four SRAM cell 10 share a part of contact plugs V0, V1 or metal traces M1, M2 with each other, that is, adjacent SRAM cell share a part of components, thus achieving the effects of simplifying the manufacturing process and reducing the cell region.

In Fig. 5, the SRAM array pattern 100 includes four regions, namely a first region R1, a second region R2, a third region R3 and a fourth region R4. Each region R1-R4 partially overlaps with the other three regions. The first region R1 to the fourth region R4 each includes an SRAM cell 10 (as shown in Fig. 2 to Fig. 4). In order to simplify the drawing, the SRAM cell located in each region in Fig. 5 simply draw the key element positions for comparison with the above figure, including the fin structure F, the first pull-up transistor PU1, the second pull-up transistor PU2, the first pull-down transistor PD1, the second pull-down transistor PD2, the first access transistor PG1, the second access transistor PG2 and the contact plugs V1. Other elements such as the gate structures G, the metal layers MOCT, the metal layers MOPY, and the metal traces M1 and M2 are omitted and not shown in Fig. 5. However, it can be understood that these elements should still exist in the SRAM array pattern 100, but they are omitted and not depicted.

The first region R1 to the fourth region R4 in Fig. 5 each contain an SRAM cell, and each SRAM cell is arranged according to certain rules. In this embodiment, the first region R1 to the fourth region R4 are arranged in a 2X2 array, the first region R1 and the second region R2 are aligned horizontally, the first region R1 and the fourth region R4 are aligned vertically, and the first region R1 and the third region R3 are located at both ends of a diagonal line, the second region R2 and the fourth region R4 are located at both ends of another diagonal line. It is worth noting that the layout of the SRAM cell in the first region R1 and the third region R3 are the same as each other, and same as the layout of the SRAM cell 10 shown in the above-mentioned Figs. 2-4 (refer to the arrangement direction of elements). The layout of the SRAM cell in the second region R2 and the fourth region R4 are the same as each other, but the layout of the SRAM cell in the second region R2 (or the fourth region R4) is different from that in the first region R1. Specifically, the layout of the SRAM cell in the first region R1 and the layout of the SRAM cell in the second region R2 (or the fourth region R4) are mirror patterns along the X axis. That is, the layout of the SRAM cell in the first region R1 and the layout of the SRAM cell in the fourth region R4 are mutually inverted patterns along a horizontal X axis.

In addition, the first region R1 partially overlaps with the other three regions. Taking the first region R1 as an example, the portion of the first region R1 that does not overlap with other regions includes the first pull-up transistor PU1, the second pull-up transistor PU2, the first pull-down transistor PD1, the second pull-down transistor PD2, the first access transistor PG1, the second access transistor PG2 and other transistors in the SRAM cell, and some contact plugs V1 are located at the portion overlapping with the first region R1 and other regions, and share the contact plugs V1 with other regions. For example, as shown in Fig. 5, the overlapping range of the first region R1 and the second region R2 is defined as OP12, and the contact plug V1 connected to the word line WL and the contact plug V1 connected to the voltage source Vss are located in the overlapping range OP12, which means that the SRAM cell in the first region R1 and the SRAM cell in the second region R2 share the contact plug V1 connected to the word line WL and the contact plug V1 connected to the voltage source Vss. The other regions are similar. The overlapping range of the first region R1 and the third region R3 is defined as OP13, and the contact plug V1 connected to the voltage source Vss is located in the overlapping range OP13. The overlapping range of the first region R1 and the fourth region R4 is defined as OP14, and the contact plug V1 connected to the voltage source Vss is located in the overlapping range OP14.

In the SRAM array pattern 100 arranged by the above four SRAM cells, since all SRAM cells share a part of the elements, the area of the whole device can be reduced. In addition, because the patterns of each SRAM cells are the same or mirror-inverted, the design of layout patterns is relatively simple, which has the advantages of easy fabrication and high yield.

In other embodiments of the present invention, the layout pattern inside the SRAM cell can be adjusted, including using 8T-SRAM or 10T-SRAM as SRAM cell as mentioned above, or changing the shape of the layout pattern, the number of elements, etc. according to the requirements, so long as the arrangement direction after being arranged into an array satisfies the rule shown in Fig. 5, it should belong to the scope of the present invention.

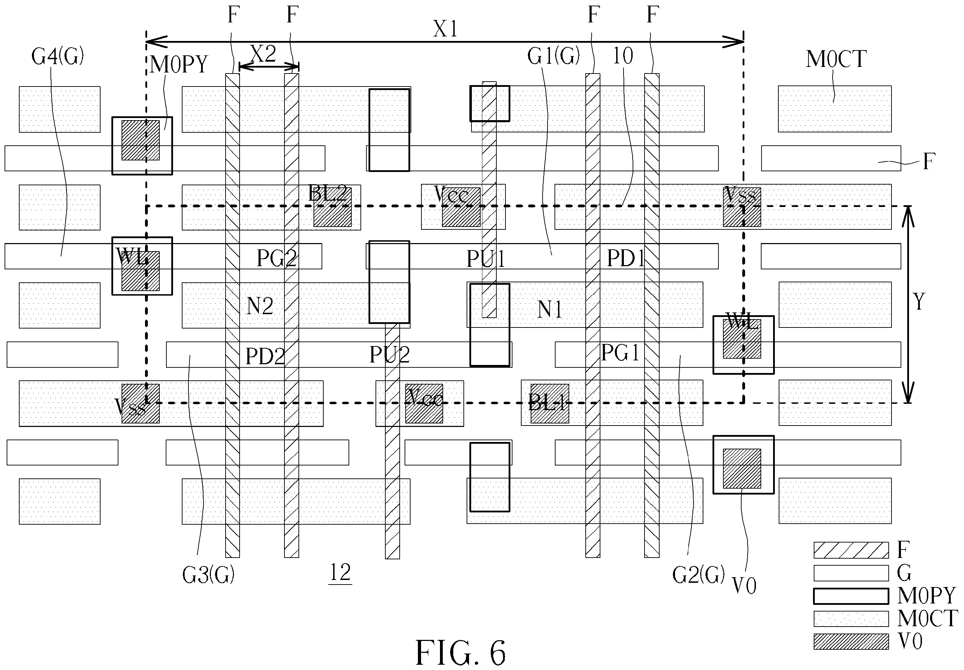

Fig. 6 shows the layout pattern of SRAM cell in another embodiment of the present invention. As shown in Fig. 6, most of the elements in this embodiment are similar to the SRAM cell in Fig. 2, so the details of these elements are not repeated. The difference between this embodiment and the embodiment in Fig. 2 is that the SRAM cell in this embodiment changes the number of fin structures F, specifically, two fin structures F pass through the first pull-down transistor PD1 and the first access transistor PG1 (in Fig. 2, only a single fin structure F pass through the first pull-down transistor PD1 and the first access transistor PG1), and two fin structures F pass through the second pull-down transistor PD2 and the second access transistor PG2 (in Fig. 2, only a single fin structure F pass through the second pull-down transistor PD2 and the second access transistor PG2). By increasing the number of fin structures, the current through the transistor can be correspondingly increased, so that devices with higher current can be fabricated. This embodiment also belongs to the scope of the present invention. In some embodiments, when the SRAM cells in different regions are combined with each other (such as the combination shown in Fig. 5), the SRAM cell in different regions may contain different numbers of fin structures F. For example, two fin structures F in the SRAM cell in the first region R1 pass through the first pull-down transistor PD1 and the first access transistor PG1, while one fin structure F in the second region R2 passes through the first pull-down transistor PD1 and the first access transistor PG1. This structure is also within the scope of the present invention.

As shown in Fig. 6, in this embodiment, the width of the region where the SRAM pattern 10 is located is defined as X1, the length is defined as Y, and the pitch between two adjacent fin structures f is defined as X2, where the ratio of X1/X2 is preferably one of the following values: 10.75, 11, 11.25 and 11.5. In addition, as for the SRAM cell shown in Fig. 2, since sufficient space has been reserved in the design, even if more fin structures F (such as the SRAM cell shown in Fig. 6) are formed in the SRAM cell, the area of the SRAM cell will not change, in other words, the area of the SRAM cell shown in Fig. 2 is the same as the area of the SRAM cell shown in Fig. 6.

According to the above description and drawings, the present invention provides a static random access memory (SRAM) array pattern, comprising: a substrate, a first region, a second region, a third region and a fourth region are defined and arranged in an array, wherein each region partially overlaps with the other three regions, each region comprises a static random access memory (SRAM) cell, wherein a layout of the SRAM cell in the first region is the same as a layout of the SRAM cell in the third region, a layout of the SRAM cell in the second region is the same as a layout of the SRAM cell in the fourth region, and the layout of the SRAM cell in the first region and the layout of the SRAM cell in the fourth region are mirror patterns along a horizontal axis.

In some embodiment of the present invention, the first region is aligned with the second region along a horizontal direction, and the first region is aligned with the fourth region in along vertical direction.

In some embodiment of the present invention, the first region, the second region, the third region and the fourth region are arranged in a 2X2 array, and the first region and the third region are located at both ends of a diagonal, while the second region and the fourth region are located at both ends of another diagonal.

In some embodiment of the present invention, the SRAM cell located in the first region further comprises at least one Vss contact electrically connected to a Vss voltage source, and a WL contact electrically connected to a word line.

In some embodiment of the present invention, the SRAM cell in the first region and the SRAM cell in the second region share the Vss contact and the WL contact, and the Vss contact and the WL contact are located in an overlapping range of the first region and the second region.

In some embodiment of the present invention, the SRAM cell in the first region and the SRAM cell in the third region share the Vss contact, but do not share the WL contact, and the Vss contact is located in an overlapping range of the first region and the third region.

In some embodiment of the present invention, the SRAM cell in the first region and the SRAM cell in the fourth region share the Vss contact, but do not share the WL contact, and the Vss contact is located in an overlapping range of the first region and the fourth region.

In some embodiment of the present invention, each SRAM cell comprises a plurality of transistors, wherein the transistors at least comprise a first pull-up transistor (PU1), a first pull-down transistor (PD1), a second pull-up transistor (PU2), a second pull-down transistor (PD2), a first access transistor (PG1) and a second access transistor (PG2)

In some embodiment of the present invention, further comprising a plurality of fin structures on the substrate, and a plurality of gate structures crossing each fin structure to form the transistors.

In some embodiment of the present invention, in the first region, one of the gate structures across one of the fin structures to form the first pull-down transistor (PD1).

In some embodiment of the present invention, in the second region, one gate structure spanning two fin structures to form the first pull-down transistor (PD1), wherein a width of the second region is defined as X1, and a pitch between the two fin structures is defined as X2, wherein X1/X2 is equal to one of the following values: 10.75, 11, 11.25 and 11.5.

In some embodiment of the present invention, an area of first region and an area of the second region are same with each other.

In some embodiment of the present invention, the first pull-up transistor (PU1), the first pull-down transistor (PD1), the second pull-up transistor (PU2), the second pull-down transistor (PD2), the first access transistor (PG1) and the second access transistor (PG2) are not located in an overlapping range of the first region and the second region.

The invention is characterized in that a layout pattern of SRAM cell is designed and arranged into an array to form an SRAM array pattern. Parts of SRAM cell can share elements, such as contact plugs. Therefore, the effects of simplifying the manufacturing process and reducing the cell area can be achieved.

## Claims

1. A static random access memory, SRAM, array pattern (100), comprising:
a substrate (12), a first region (R1), a second region (R2), a third region (R3) and a fourth region (R4) are defined and arranged in an array, wherein each region partially overlaps with the other three regions;
each region comprises a static random access memory, SRAM, cell;
wherein a layout of the SRAM cell in the first region (R1) is the same as a layout of the SRAM cell in the third region (R3), a layout of the SRAM cell in the second region (R2) is the same as a layout of the SRAM cell in the fourth region (R4), and the layout of the SRAM cell in the first region (R1) and the layout of the SRAM cell in the fourth region (R4) are mirror patterns along a horizontal axis.

2. The SRAM array pattern (100) of claim 1, wherein the first region (R1) is aligned with the second region (R2) along a horizontal direction, and the first region (R1) is aligned with the fourth region (R4) in along vertical direction.

3. The SRAM array pattern (100) of claim 1 or 2, wherein the first region (R1), the second region (R2), the third region (R3) and the fourth region (R4) are arranged in a 2X2 array, and the first region (R1) and the third region (R3) are located at both ends of a diagonal, while the second region (R2) and the fourth region (R4) are located at both ends of another diagonal.

4. The SRAM array pattern (100) of one of the claims 1 to 3, wherein the SRAM cell located in the first region (R1) further comprises at least one voltage source, Vss, contact electrically connected to a Vss voltage source, and a world line, WL, contact electrically connected to a word line.

5. The SRAM array pattern (100) of claim 4, wherein the SRAM cell in the first region (R1) and the SRAM cell in the second region (R2) share the Vss contact and the WL contact, and the Vss contact and the WL contact are located in an overlapping range of the first region (R1) and the second region (R2).

6. The SRAM array pattern (100) of claim 4, wherein the SRAM cell in the first region (R1) and the SRAM cell in the third region (R3) share the Vss contact, but do not share the WL contact, and the Vss contact is located in an overlapping range of the first region (R1) and the third region (R3).

7. The SRAM array pattern (100) of claim 4, wherein the SRAM cell in the first region (R1) and the SRAM cell in the fourth region (R4) share the Vss contact, but do not share the WL contact, and the Vss contact is located in an overlapping range of the first region (R1) and the fourth region (R4).

8. The SRAM array pattern (100) of one of the claims 1 to 7, wherein each SRAM cell comprises a plurality of transistors, wherein the transistors at least comprise a first pull-up transistor (PU1), a first pull-down transistor (PD1), a second pull-up transistor (PU2), a second pull-down transistor (PD2), a first access transistor (PG1) and a second access transistor (PG2).

9. The SRAM array pattern (100) of claim 8, further comprising a plurality of fin structures (F) on the substrate (12), and a plurality of gate structures (G) crossing each fin structure (F) to form the transistors.

10. The SRAM array pattern (100) of claim 9, wherein in the first region (R1), one of the gate structures (G1) across one of the fin structures (F) to form the first pull-down transistor (PD1).

11. The SRAM array pattern (100) of claim 10, wherein in the second region (R2), one gate structure spanning two fin structures to form the first pull-down transistor (PD1), wherein a width of the second region is defined as X1, and a pitch between the two fin structures is defined as X2, wherein X1/X2 is equal to one of the following values: 10.75, 11, 11.25 and 11.5.

12. The SRAM array pattern (100) of claim 11, wherein an area of first region (R1) and an area of the second region (R2) are same with each other.

13. The SRAM array pattern (100) of claim 8, wherein the first pull-up transistor (PU1), the first pull-down transistor (PD1), the second pull-up transistor (PU2), the second pull-down transistor (PD2), the first access transistor (PG1) and the second access transistor (PG2) are not located in an overlapping range of the first region (R1) and the second region (R2).
